# EUROPÄISCHE PATENTANMELDUNG

(11) **EP 4 001 938 A1**
(43) Veröffentlichungstag der Anmeldung: **25.05.2022**
(21) Anmeldenummer: 20206940.7
(22) Anmeldetag: 11.11.2020
(51) Int. Cl.: G01R 31/367

(54) **COMPUTERGESTÜTZTES VERFAHREN ZUM BESTIMMEN VON ZUSTANDSGRÖSSEN EINES BATTERIESPEICHERS UND BATTERIESPEICHER**

(71) Anmelder: Siemens Aktiengesellschaft, 80333 München (DE)
(72) Erfinder: Schricker, Barbara, 91058 Erlangen (DE)

(57) **Zusammenfassung**

Die Erfindung betrifft ein computergestütztes Verfahren zum Bestimmen von Zustandsgrößen eines Batteriespeichers mit mehreren Schritten. Zunächst erfolgt das Einrichten eines Batteriesimulationsmodul. Das Batteriesimulationsmodul weist ein Batteriespeichermodell auf, welches das dynamische Betriebsverhalten des Batteriespeichers beschreibt. Das Batteriesimulationsmodul umfasst ein Ersatzschaltbildmodell, wenigstens einen Ladungszähler und ein Alterungsmodell. Das Ersatzschaltbildmodell umfasst wenigstens eine ladezustandsabhängige Spannungsquelle und wenigstens einen Widerstand. Es werden gemessene Betriebsdaten des Batteriespeichers und Parametrierungsdaten für das Batteriespeichermodell empfangen. Die Parametrierungsdaten mit dem Ersatzschaltbildmodell beschreiben den Betrieb des Batteriespeichers in einem Neuzustand. Die gemessenen Betriebsdaten und die Parametrierungsdaten werden an das Batteriespeichermodell übermittelt. In dem Batteriespeichermodell erfolgt eine Simulation eines Betriebs des Batteriespeichers. Basierend auf dem simulierten Betrieb des Batteriespeichers werden simulierte Betriebsdaten des Batteriespeichers ermittelt. Basierend auf einem Optimierungsverfahren werden die Zustandsgrößen des Batteriespeichers bestimmt. In dem Optimierungsverfahren erfolgt ein Vergleich der gemessenen Betriebsdaten mit den simulierten Betriebsdaten. Der Batteriespeicher umfasst weiterhin eine Recheneinheit, auf der das computergestützte Verfahren ausgeführt werden kann.

## Beschreibung

Die Erfindung betrifft ein Computergestütztes Verfahren zum Bestimmen von Zustandsgrößen eines Batteriespeichers und einen Batteriespeicher.

Lithium-Ionen-Akkumulatoren, im Folgenden auch Lithium-Ionen-Batterien genannt, werden aufgrund ihrer hohen Leistungsdichte und Energiedichte in mobilen und stationären Anwendungen als Energiespeicher eingesetzt. Um diese elektrischen Energiespeicher sicher, zuverlässig und eine lange Zeitdauer wartungsfrei betreiben zu können, ist eine möglichst genaue Kenntnis kritischer Betriebszustände, insbesondere hinsichtlich des Ladezustands (engl.: State of Charge) nötig.

Eine ausreichende Menge bereitstellbarer elektrischer Energie ist von hoher Relevanz für einen zuverlässigen und sicheren Betrieb bei Anwendungen im mobilen Bereich, insbesondere in elektrisch betriebenen Fahrzeugen. Um die Menge der bereitstellbaren elektrischen Energiemenge genau zu kennen, ist es nötig, dass ein Ladezustand eines Batteriespeichers genau bestimmt wird. Ein genaues Bestimmen des Ladezustands ist insbesondere auch für den Betrieb von stationären Batteriespeichern, insbesondere beim Bereitstellen von Regelleistung an ein Energienetz, wichtig, um die bereitstellbare Energiemenge genau zu kennen.

Derzeit wird als eine Zustandsgröße des Batteriespeichers der Ladezustand basierend auf einer Ladungszählung (auch Ah-Zählung) während des Betriebs des Batteriespeichers ermittelt. Zusätzlich wird der Ladezustand basierend auf einer Messung der Ruhespannung (während Betriebspausen) über eine Ruhespannungskennlinie korrigiert.

Nachteilig ist, dass die Messung des Gesamtladungszählwerts, also der elektrischen Ladung, die den Batteriespeicher insgesamt lädt oder entlädt, aufgrund unterschiedlicher Effekte ungenau sein kann. Somit wird auch der Ladezustand des Batteriespeichers nachteilig ungenau bestimmt.

Aufgrund dieser Ungenauigkeit der Messungen werden Batteriespeicher häufig überdimensioniert, um eine ausreichende verfügbare Kapazität, insbesondere in den genannten Anwendungen, zu gewährleisten. Dies hat nachteilig höhere Investitionskosten für den Batteriespeicher zur Folge.

Eine bereitstellbare oder aufnehmbare Leistung des Batteriespeichers hängt auch von dem Gesundheitszustand (engl.: state of health) der Batterie ab. Der Gesundheitszustand wird auch als Zustandsgröße verstanden. Insbesondere nimmt die Kapazität des Batteriespeichers während der Lebensdauer des Batteriespeichers ab. Auch die Dynamik des Betriebs des Batteriespeichers, also das Reaktionsverhalten, nimmt, insbesondere aufgrund eines steigenden Innenwiderstands, mit steigender Betriebsdauer ab.

Es ist für einen Nutzer des Batteriespeichers wichtig, während des Betriebs Kenntnis über Zustandsdaten des Batteriespeichers zu haben. Diese Zustandsdaten sind allerdings nicht direkt messbar. Es erfolgt, typischerweise in einem Batteriemanagementsystem, das Ermitteln von Zustandsgrößen mittels Algorithmen. Nachteilig sind die ermittelten Zustandsgrößen aufgrund von Messungenauigkeiten, Störsignalen, oder Abschätzungsfehlern häufig ungenau.

Es ist somit Aufgabe der vorliegenden Erfindung ein Verfahren zum Bestimmen von Zustandsgrößen eines Batteriespeichers und einen Batteriespeicher anzugeben, welche das Bestimmen von Zustandsgrößen des Batteriespeichers mit hoher Genauigkeit erlaubt.

Die Aufgabe wird mit einem Verfahren mit den Merkmalen gemäß Anspruch 1 und einem Batteriespeicher mit den Merkmalen gemäß Anspruch 14 gelöst.

Das erfindungsgemäße computergestützte Verfahren zum Bestimmen von Zustandsgrößen eines Batteriespeichers umfasst mehrere Schritte. Zunächst erfolgt das Einrichten eines Batteriesimulationsmoduls, welches das dynamische Betriebsverhalten des Batteriespeichers beschreibt. Das Batteriesimulationsmodul weist ein Batteriespeichermodell auf. Das Batteriespeichermodell umfasst ein Ersatzschaltbildmodell und wenigstens einen Ladungszähler. Das Ersatzschaltbildmodell umfasst wenigstens eine ladezustandsabhängige Spannungsquelle und wenigstens einen Widerstand. Weiterhin werden gemessene Betriebsdaten des Batteriespeichers empfangen. In anderen Worten werden gemessene Betriebsdaten des Batteriespeichers für das erfindungsgemäße Verfahren bereitgestellt. Es werden weiterhin Parametrierungsdaten für das Ersatzschaltbildmodell empfangen, wobei die Parametrierungsdaten und das Ersatzschaltbildmodell den Betrieb des Batteriespeichers einem Neuzustand beschreiben. Die gemessenen Betriebsdaten und die Parametrierungsdaten werden an das Ersatzschaltbildmodell übermittelt. Anschließend wird ein Betrieb des Batteriespeichers mittels des Batteriesimulationsmoduls simuliert. Basierend auf der Simulation werden simulierte Betriebsdaten des Batteriespeichers ermittelt. Basierend auf einem Optimierungsverfahren, welches einen Vergleich der gemessenen Betriebsdaten mit den simulierten Betriebsdaten durchführt, werden die Zustandsgrößen des Batteriespeichers bestimmt.

Der erfindungsgemäße Batteriespeicher umfasst eine Recheneinheit, welche eingerichtet ist, das erfindungsgemäße Verfahren durchzuführen.

Unter einem Batteriesimulationsmodul wird im Zusammenhang mit der Erfindung beispielsweise ein Prozessor und/oder eine Speichereinheit zum Speichern von Programmbefehlen verstanden. Insbesondere ist der Prozessor speziell dazu eingerichtet, die Programmbefehle derart auszuführen, dass der Prozessor Funktionen ausführt, um das Simulieren des Betriebs des Batteriespeichers zu implementieren.

Während des Optimierungsverfahrens werden insbesondere die Batteriezustände des Ersatzschaltbildmodells optimiert.

Dieses Empfangen oder Bereitstellen von Daten erfolgt beispielsweise als Download in Form eines Programmdatenblocks und/oder Befehlsdatenblocks, vorzugsweise als Datei, insbesondere als Downloaddatei, oder als Datenstrom, insbesondere als Downloaddatenstrom. Dieses Empfangen oder Bereitstellen kann beispielsweise aber auch als partieller Download erfolgen, der aus mehreren Teilen besteht und insbesondere über ein Peer-to-Peer Netzwerk heruntergeladen oder als Datenstrom bereitgestellt wird.

Sofern es in der nachfolgenden Beschreibung nicht anders angegeben ist, beziehen sich die Begriffe "simulieren", "ermitteln", "bestimmen", "rechnergestützt", "rechnen", "feststellen", "generieren", "konfigurieren" und dergleichen, vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt werden oder vorliegen können, beispielsweise als elektrische Impulse.

Die Betriebsdaten werden insbesondere in Form von unterteilten Zeitreihen, also einzelnen Zeitreihen-Abschnitten, eingeteilt und eingesetzt. Als Betriebsdaten werden insbesondere eine Spannung, ein Strom, eine Temperatur und/oder ein Ladezustand verstanden.

Die Parametrierungsdaten für das Batteriespeichermodell beschreiben zusammen mit dem Batteriespeichermodell den Betrieb des Batteriespeichers in einem Neuzustand. Die Parametrierungsdaten können insbesondere basierend auf experimentellen Messmethoden ermittelt werden.

Als Zustandsgrößen werden insbesondere der Ladezustand und/oder wenigstens ein Gesundheitszustand bestimmt. Eine genaue Kenntnis des Ladezustands und/oder eines Gesundheitszustandes ermöglicht es vorteilhaft, den weiteren Betrieb des Batteriespeichers in optimaler Weise zu planen. Es ermöglicht weiterhin, Vorhersagen zu treffen, insbesondere über eine Restlebensdauer des Batteriespeichers.

In einer weiteren vorteilhaften Ausgestaltung und Weiterbildung der Erfindung werden als gemessene Betriebsdaten ein zeitlicher Spannungsverlauf und als simulierte Betriebsdaten ein simulierter zeitlicher Spannungsverlauf verwendet. Vorteilhaft kann der Spannungsverlauf einfach gemessen werden. Vorteilhaft werden die Messungen auf Qualität und/oder Plausibilität überprüft. In Abhängigkeit eines Qualitätsüberprüfungsergebnisses werden die gemessenen Betriebsdaten für das Optimierungsverfahren ausgewählt. Dies verbessert vorteilhaft die Qualität der gemessenen Betriebsdaten und somit auch die Qualität der ermittelten Zustandsgrößen.

In einer weiteren vorteilhaften Ausgestaltung und Weiterbildung der Erfindung werden als gemessene Betriebsdaten ein mittels einer Ladungszählmethode ermittelter zeitlicher Ladezustandsverlauf verwendet und als simulierte Betriebsdaten ein simulierter zeitlicher Ladezustandsverlauf verwendet. Auch hier ist es vorteilhaft die Messungen auf Qualität und/oder Plausibilität zu überprüfen. Es erfolgt dann in Abhängigkeit eines Qualitätsüberprüfungsergebnisses eine Auswahl der verwendeten gemessenen Betriebsdaten. Die Bestimmung der Zustandsgrößen basierend auf den Abgleich der zeitlichen Ladezustandsverläufe erhöht vorteilhaft gegenüber dem der zeitlichen Spannungsverläufe die Qualität der ermittelten Zustandsgrößen.

In einer weiteren vorteilhaften Ausgestaltung und Weiterbildung der Erfindung umfasst das Ersatzschaltbildmodell wenigstens ein RC-Glied, insbesondere zwei RC-Glieder. Die RC-Glieder ermöglichen es vorteilhaft, das dynamische Verhalten von Batteriespeichern in verschiedenen Zeitbereichen nachzubilden.

In einer weiteren vorteilhaften Ausgestaltung und Weiterbildung der Erfindung weist ein RC Glied eine Zeitkonstante in einem Bereich von 5 Sekunden bis 100 Sekunden auf und/oder wenigstens ein RC Glied eine Zeitkonstante in einem Bereich von 100 Sekunden bis 20 Minuten. Die Verwendung der angegeben Zeitkonstanten erlaubt vorteilhaft eine Beschreibung des dynamische Verhaltens von Batteriespeichern in dem zeitlichen Bereich (Sekunden- bis Minutenbereich), welcher in gespeicherten Daten (mit üblichen Aufzeichnungsraten) abgebildet ist.

In einer weiteren vorteilhaften Ausgestaltung und Weiterbildung der Erfindung werden in den Parametrierungsdaten für das Ersatzschaltbildmodell umfasste Parameter in Abhängigkeit eines Ladezustands, einer Temperatur, einer Stromrichtung, eine Ruhespannung und/oder einer C-Rate festgelegt Die Berücksichtigung all dieser Abhängigkeiten erfordert zwar Messungen im Vorfeld, ermöglicht dafür aber vorteilhaft eine hohe Modellgenauigkeit. Die hohe Modellgenauigkeit ermöglicht vorteilhaft eine erhöhte Genauigkeit der zu bestimmenden Zustandsgrößen aus.

In einer weiteren vorteilhaften Ausgestaltung und Weiterbildung der Erfindung wird basierend auf Messungen während des Ladens und Entladens des Batteriespeichers eine Hysterese der Ruhespannungskennlinie bestimmt, welche die Abhängigkeit der Ruhespannungskennlinie von der Stromrichtung des Batteriespeichers im Neuzustand beschreibt. Vorteilhaft wird somit miteinbezogen, dass die Ruhespannungskennlinie eine Hysterese aufweist. Besonders vorteilhaft wird die Hysterese der Ruhespannungskennlinie in Abhängigkeit der Temperatur und/oder der elektrischen Last bestimmt. Weiterhin ist es somit vorteilhaft möglich, Alterungseffekte im Batteriespeicher durch einen Abgleich mit der Ruhespannungskennlinie im Neuzustand mit einer zu einem späteren Zeitpunkt durchgeführten Messung der Ruhespannungskennlinie, zu erkennen.

In einer weiteren vorteilhaften Ausgestaltung und Weiterbildung der Erfindung wird in dem Batteriespeichermodell eine Alterungsfunktion für wenigstens eine Batteriekapazität und/oder für einen Innenwiderstand und/oder für die Ruhespannung verwendet. Die Alterungsfunktion beschreibt insbesondere die Abnahme der Speicherkapazität und den steigenden Innenwiderstand des Batteriespeichers in Abhängigkeit einer zunehmenden Betriebsdauer. Vorteilhaft wird somit die Alterung des Batteriespeichers bei Bestimmung der Zustandsgrößen des Batteriespeichers mit einbezogen, was die Genauigkeit der Ermittlung der Zustandsgrößen erhöht.

In einer weiteren vorteilhaften Ausgestaltung und Weiterbildung der Erfindung werden die ermittelten Zustandsgrößen zu einer Steuerung des Batteriespeichers verwendet und/oder zu Vorhersagen von verbleibender Lebensdauer des Batteriespeichers und/oder zur Ermittlung von Wartungsintervallen eingesetzt. Vorteilhaft kann somit einerseits die Steuerung des Batteriespeichers derart erfolgen, dass die Lebensdauer des Batteriespeichers möglichst lang ist. Weiterhin kann ein Austausch eines Batteriespeichers in Abhängigkeit der verbleibenden Lebensdauer vorteilhaft frühzeitig geplant werden. Ein plötzliches unvorhergesehenes Versagen des Batteriespeichers wird somit vorteilhaft verhindert. Weiterhin können Wartungen individuell auf einem Batteriespeicher und dessen Betrieb angepasst werden.

In einer weiteren vorteilhaften Ausgestaltung und Weiterbildung der Erfindung werden basierend auf den ermittelten Zustandsgrößen zeitabhängige Zustandsgrößen-Zeitreihen ermittelt, wobei die Zustandsgrößen-Zeitreihen mit den Betriebsdaten in ein Maschinenlernverfahren eingebracht werden, welches Alterungsmodelle erzeugt. Zur Beschreibung der Alterung von Lithium-Ionen-Batterien werden häufig empirische Alterungsmodelle erstellt und verwendet. Die Qualität solcher Modelle steigt mit der Qualität und Quantität der zugrunde liegenden Datenbasis. In der Praxis ist man nachteilig häufig durch eine wenig umfangreiche Datengrundlage limitiert. Eine Erweiterung der Datengrundlage, wie hier beschrieben, erhöht vorteilhaft die Qualität der empirischen Alterungsmodelle.

Weitere Merkmale, Eigenschaften und Vorteile der vorliegenden Erfindung ergeben sich aus der nachfolgenden Beschreibung unter Bezugnahme auf die beiliegenden Figuren. Darin zeigen schematisch:
- Figur 1: ein Batteriesimulationsmodul mit gemessenen Betriebsdaten und Parametrierungsdaten als Eingangsgröße und Zustandsgrößen als Ausgangsgröße;
- Figur 2: eine schematische Verfahrensübersicht zum Bestimmen von Zustandsgrößen eines Batteriespeichers.

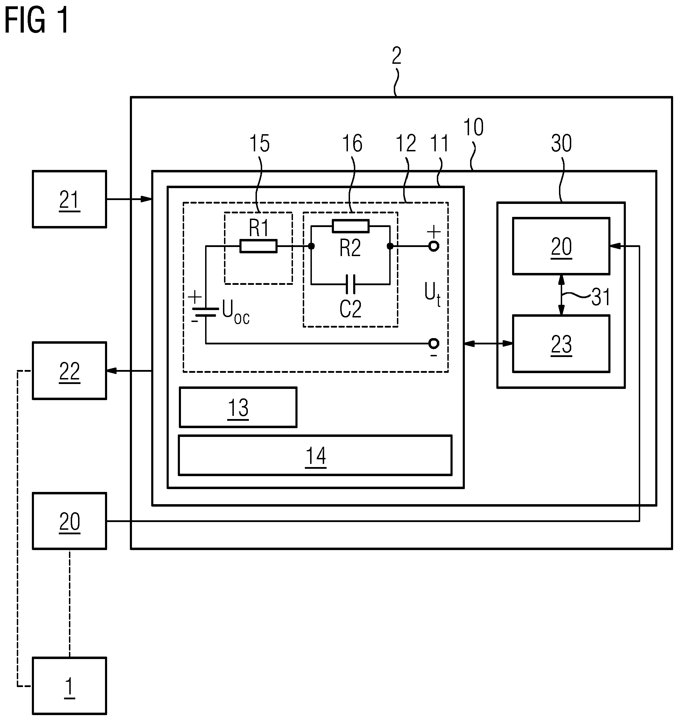

Figur 1 zeigt einen Batteriespeicher 1 und eine Recheneinheit 2. die Batteriespeichereinheit 1 und die Recheneinheit 2 können Daten austauschen. Die Recheneinheit 2 umfasst ein Batteriesimulationsmodul 10. Das Batteriesimulationsmodul 10 umfasst ein Batteriespeichermodell 11 und ein Optimierungsmodul 30.

Das Batteriespeichermodell 11 weist ein Ersatzschaltbildmodell 12, einen Ladungszähler 13 und ein Alterungsmodell 14 auf. Das Ersatzschaltbildmodell 12 weist ein erstes Ersatzschaltbildelement 15 und ein zweites Ersatzschaltbildelement 16 auf. Das Ersatzschaltbildmodell 12 weist weiterhin eine ladezustandsabhängige Spannungsquelle U_{OC} auf.

Dem Ersatzschaltbildmodell 12 werden Parametrierungsdaten 21 zugeführt. Die von den Parametrierungsdaten 21 umfassten Parameter der Ersatzschaltbildelemente 15, 16 werden insbesondere in Abhängigkeit eines Ladezustands, einer Temperatur, einer Stromrichtung, einer Ruhespannung und/oder einer C-Rate festgelegt. Die Spannung der ladezustandsabhängigen Spannungsquelle U_{OC} wird in Abhängigkeit vom Ladezustand und der Stromrichtung festgelegt. In dem Batteriesimulationsmodul 10 erfolgt dann mittels des Batteriespeichermodells 11, welches das Ersatzschaltbildmodell 12 umfasst, eine Simulation von Betriebsdaten des Batteriespeichers 1. Die simulierten Betriebsdaten 23 werden anschließend an das Optimierungsmodul 30 übertragen. Die simulierten Betriebsdaten werden in jedem Optimierungsiterationsschritt neu berechnet. Das Optimierungsmodul gibt in jedem Optimierungsschritt die neu berechneten Zustandsgrößen an das Batteriespeichermodell zurück.

Weiterhin werden die gemessenen Betriebsdaten 20, welche im Neuzustand des Batteriespeichers gemessen wurden, an das Optimierungsmodul 30 übertragen. Die Betriebsdaten des Batteriespeichers 1 werden also direkt an die Recheneinheit 2 übertragen. Als gemessene Betriebsdaten 20 werden insbesondere ein zeitlicher Spannungsverlauf oder ein zeitlicher Ladezustandsverlauf verwendet. In dem Optimierungsmodul 30 erfolgt ein Datenvergleich 31 der gemessenen Betriebsdaten 20 und der simulierten Betriebsdaten 23 durch Änderung der Zustandsgrößen. Der Datenvergleich 31 erfolgt insbesondere mittels der Methode der kleinsten Fehlerquadrate (engl. leastsquare-fit). Mittels des Datenvergleichs 31 werden Zustandsgrößen 22 des Batteriespeichers 1 bestimmt. Als Zustandsgrößen 22 werden insbesondere der Ladezustand und/oder ein Gesundheitszustand bestimmt.

Die bestimmten Zustandsgrößen 22 können zum Steuern des Batteriespeichers 1 an diesen übertragen werden.

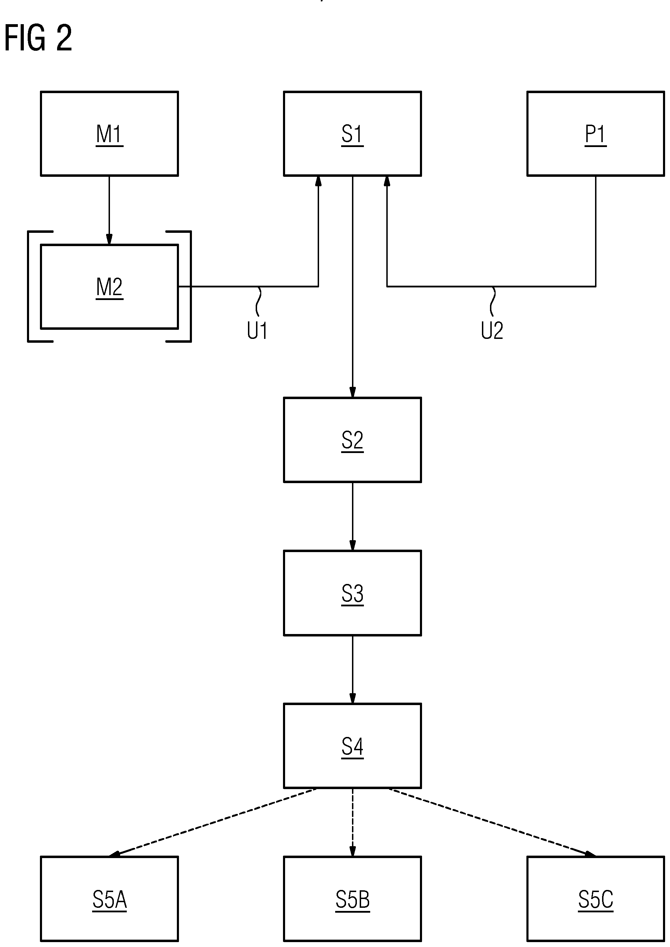

Figur 2 zeigt eine schematische Übersicht über das computergestützte Verfahren zum Bestimmen von Zustandsgrößen eines Batteriespeichers. Es werden zunächst gemessene Betriebsdaten empfangen bzw. bereitgestellt M1. Diese gemessenen Betriebsdaten werden in einem nächsten Schritt M2 auf Qualität und Plausibilität überprüft werden. Weiterhin werden Parametrierungsdaten bereitgestellt bzw. empfangen P1. Weiterhin erfolgt das Einrichten eines Batteriespeichermodells in einem Verfahrensschritt S1. Die gemessenen Betriebsdaten werden in einem weiteren Schritt U1 an das Batteriespeichermodell übertragen. In einem weiteren Schritt U2 werden die Parametrierungsdaten ebenfalls an das Batteriespeichermodell übertragen. In einen nächsten Schritt S2 erfolgt das Simulieren eines Betriebs des Batteriespeichers. Anschließend erfolgt in einem nächsten Schritt S3 das Ermitteln der simulierten Betriebsdaten. Basierend darauf werden in einem nächsten Schritt S4 die Zustandsgrößen des Batteriespeichers bestimmt. Basierend auf den Zustandsgrößen kann dann ein Steuern des Batteriespeichers S5A und/oder eine Vorhersage der verbleibenden Lebensdauer des Batteriespeichers S5B und/oder eine Vorhersage von Wartungsintervallen S5C erfolgen.

Obwohl die Erfindung im Detail durch das bevorzugte Ausführungsbeispiel näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die nachfolgenden Patentansprüche definiert wird, zu verlassen.

### Bezugszeichenliste

- 1: Batteriespeicher
- 2: Recheneinheit
- 10: Batteriesimulationsmodul
- 11: Batteriespeichermodell
- 12: Ersatzschaltbildmodell
- 13: Ladungszähler
- 14: Alterungsmodell
- 15: erstes Ersatzschaltbildelement
- 16: zweites Ersatzschaltbildelement
- 20: gemessene Betriebsdaten
- 21: Parametrierungsdaten
- 22: Zustandsgrößen
- 23: simulierte Betriebsdaten
- 30: Optimierungsmodul
- 31: Datenvergleich
- UOC: Spannungsquelle
- R1: erster Widerstand
- R2: zweiter Widerstand
- C2: zweiter Kondensator
- Ut: zeitabhängige Spannung
- S1: Einrichten eines Batteriespeichermodells
- S2: Simulieren eines Betriebs des Batteriespeichers
- S3: ermitteln simulierter Betriebsdaten
- S4: Bestimmen der Zustandsgrößen des Batteriespeichers
- S5A: Steuern des Batteriespeichers
- S5B: Vorhersage verbleibender Lebensdauer
- S5C: Vorhersage von Wartungsintervallen
- M1: Empfangen von gemessenen Betriebsdaten
- M2: Überprüfen von Qualität und Plausibilität der gemessenen Betriebsdaten
- P1: Empfangen von Parametrierungsdaten
- U1: erstes Übertragen der gemessenen Betriebsdaten
- U2: zweites Übertragen der Parametrierungsdaten

## Patentansprüche

1. Computergestütztes Verfahren zum Bestimmen von Zustandsgrößen (22) eines Batteriespeichers (1) mit mehreren Schritten:
- Einrichten eines Batteriesimulationsmoduls (10), welches das dynamische Betriebsverhalten des Batteriespeichers (1) beschreibt, wobei das Batteriesimulationsmodul (10) ein Batteriespeichermodell (11) aufweist, welches ein Ersatzschaltbildmodell (12) und wenigstens einen Ladungszähler umfasst, wobei das Ersatzschaltbildmodell (12) wenigstens eine ladezustandsabhängige Spannungsquelle (U_{OC}) und wenigstens einen Widerstand (R₁, R₂) umfasst,
- Empfangen von gemessenen Betriebsdaten (20) des Batteriespeichers (1),
- Empfangen von Parametrierungsdaten (21) für das Ersatzschaltbildmodell (12), wobei die Parametrierungsdaten (21) und das Ersatzschaltbildmodell (12) den Betrieb des Batteriespeichers (1) in einem Neuzustand beschreiben,
- Übermitteln der gemessenen Betriebsdaten (20) und der Parametrierungsdaten (21) an das Ersatzschaltbildmodell (12),
- Simulieren eines Betriebs des Batteriespeichers (1) in dem Batteriesimulationsmodul (10),
- Ermitteln simulierter Betriebsdaten (23) des Batteriespeichers basierend auf dem simulierten Betrieb des Batteriespeichers (1),
- Bestimmen der Zustandsgrößen (22) des Batteriespeichers (1) basierend auf einem Optimierungsverfahren basierend auf einem Vergleich der gemessenen Betriebsdaten (20) mit den simulierten Betriebsdaten (23).

2. Computergestütztes Verfahren nach Anspruch 1, wobei als Zustandsgröße (22) der Ladezustand und/oder wenigstens ein Gesundheitszustand bestimmt werden.

3. Computergestütztes Verfahren nach einem der vorhergehenden Ansprüche, wobei als gemessene Betriebsdaten (20) ein zeitlieher Spannungsverlauf und als simulierte Betriebsdaten (23) ein simulierter zeitlicher Spannungsverlauf verwendet wird.

4. Computergestütztes Verfahren nach einem der Ansprüche 1 oder 2, wobei als gemessene Betriebsdaten (20) ein mittels einer Ladungszählmethode ermittelter zeitlicher Ladezustandsverlauf verwendet wird und als simulierte Betriebsdaten (23) ein simulierter zeitlicher Ladezustandsverlauf verwendet wird.

5. Computergestütztes Verfahren nach einem der vorhergehenden Ansprüche, wobei das Ersatzschaltbildmodell (12) wenigstens ein RC-Glied, insbesondere zwei RC-Glieder, umfasst.

6. Computergestütztes Verfahren nach Anspruch 5, wobei wenigstens ein RC-Glied eine Zeitkonstante in einem Bereich von 5 s bis 100 s aufweist und/oder wenigstens ein RC-Glied die Zeitkonstante in einem Bereich von 100 s bis 20 min aufweist.

7. Computergestütztes Verfahren nach einem der vorhergehenden Ansprüche, wobei die Parametrierungsdaten (21) für das Ersatzschaltbildmodell (12) in Abhängigkeit eines Ladezustands, einer Temperatur, einer Stromrichtung, eine Ruhespannung und/oder einer C-Rate festgelegt werden.

8. Computergestütztes Verfahren nach Anspruch 7, wobei die Parametrierungsdaten (21) eine Hysterese der Ruhespannungskennlinie umfassen, welche die Abhängigkeit der Ruhespannungskennlinie von der Stromrichtung des Batteriespeichers (1) im Neuzustand beschreibt

9. Computergestütztes Verfahren nach Anspruch 8, wobei die Hysterese der Ruhespannungskennlinie in Abhängigkeit der Temperatur und/oder der elektrischen Last bestimmt wird.

10. Computergestütztes Verfahren nach einem der vorhergehenden Ansprüche, wobei das Batteriespeichermodell (11) ein Alterungsmodell (14) für wenigstens eine Batteriekapazität und/oder für einen Innenwiderstand und/oder für die Ruhespannung umfasst.

11. Computergestütztes Verfahren nach einem der vorhergehenden Ansprüche, wobei die ermittelten Zustandsgrößen (22) zu einer Steuerung des Batteriespeichers (1) verwendet werden und/oder zu Vorhersagen von verbleibender Lebensdauer des Batteriespeichers (1) und/oder von Wartungsintervallen des Batteriespeichers (1) eingesetzt werden.

12. Computergestütztes Verfahren nach einem der Ansprüche 1 bis 11, wobei basierend auf den ermittelten Zustandsgrößen (22) zeitabhängige Zustandsgrößen-Zeitreihen ermittelt werden, wobei die Zustandsgrößen-Zeitreihen mit wenigstens einem Belastungsprofil des Batteriespeichers in ein Maschinen-Lern-Verfahren eingebracht werden, welches Alterungsmodelle erzeugt.

13. Computergestütztes Verfahren nach einem der vorhergehenden Ansprüche, wobei die gemessenen Betriebsdaten (20) auf Qualität und/oder Plausibilität überprüft werden und in Abhängigkeit eines Qualitätsüberprüfungsergebnisses für das Optimierungsverfahren ausgewählt werden.

14. Batteriespeicher (1) mit einer Recheneinheit (2), welche eingerichtet ist, ein Verfahren gemäß einem der Ansprüche 1 bis 13 computergestützt auszuführen.

15. Batteriespeicher (1) gemäß Anspruch 14, wobei die Recheneinheit (2) lokal getrennt vom Batteriespeicher (1) angeordnet ist und eingerichtet ist, mit dem Batteriespeicher (1) per Fernzugriff über ein Netzwerk Daten auszutauschen.
